# EUROPÄISCHE PATENTSCHRIFT

(11) **EP 1 961 095 B1**
(45) Veröffentlichungstag und Bekanntmachung des Hinweises auf die Patenterteilung: **07.08.2019**
(21) Anmeldenummer: 06806429.4
(22) Anmeldetag: 20.10.2006
(51) Int. Cl.: H02G 5/04, H02G 5/08

(54) **SYSTEM, UMFASSEND PROFILSCHIENE UND BOX**
SYSTEM COMPRISING A PROFILED RAIL AND BOX
SYSTEME COMPRENANT UN RAIL PROFILE ET UN BOITIER

(30) Priorität: 11.11.2005 DE 102005054252
(43) Veröffentlichungstag der Anmeldung: 27.08.2008
(73) Patentinhaber: SEW-EURODRIVE GmbH & Co. KG, 76646 Bruchsal (DE)
(72) Erfinder: BECKER, Günter, 76684 Östringen (DE); WOLF, Konstantin, 76698 Ubstadt-Weiher (DE); SCHWESINGER, Klaus, 76646 Bruchsal (DE)
(86) Internationale Anmeldenummer: PCT/EP2006/010128
(87) Internationale Veröffentlichungsnummer: WO 2007/054194

(56) Entgegenhaltungen:
- EP-A1- 0 465 099
- EP-A2- 0 241 318
- DE-A1- 3 245 384
- DE-A1- 3 437 586
- DE-A1- 19 540 339
- DE-U- 1 847 856
- GB-A- 2 263 933
- US-A- 5 214 314

## Beschreibung

Die Erfindung betrifft ein System, umfassend Profilschiene und Box.

Aus der DE 10014954 und der DE 10147859 ist ein System zur berührungslosen Energieübertragung bekannt, bei dem mittelfrequente Starkströme im Primärleiter vorgesehen sind und Leistungen von mehr als 300 W an bewegbar angeordnete Verbraucher übertragbar sind.

Aus der EP 0 465 099 A1 ist ein Kabelkanal bekannt, der an seiner Innenseite Längsnuten aufweist, in die eine Box mit einem drehbaren Teilbereich eingehängt wird, wobei entsprechende Drehbewegungskombinationen der gesamten Box ausgeführt werden, also eine erste Drehung um eine erste Achse und danach eine zweite Drehung um eine hierzu senkrechte Achse. Die Box und der drehbare Teilbereich sind fest zusammengehörig. Ein Austauschen der Box ist also nur mit Austauschen des drehbaren Teilbereichs und somit Lösen der Verbindung mit dem Kabelkanal möglich.

Aus der GB 2 263 933 A ist ein Stahlblechteil bekannt, das elastisch verformbar ist und somit mittels Federkraft in einer Längsnut haltbar ist.

Aus der EP 0 241 318 A2 ist ein Niedrigspannungssystem in einer Zweileiterführung bekannt.

Der Erfindung liegt die Aufgabe zugrunde, ein System mit Profilschiene und Box derart weiterzubilden, wobei die Installation möglichst einfach, schnell und kostengünstig ausführbar sein soll.

Erfindungsgemäß wird die Aufgabe bei dem System nach den in Anspruch 1 angegebenen Merkmalen gelöst.

Wichtige Merkmale der Erfindung bei dem System sind, dass es Profilschiene und Box umfasst, wobei die Box am Halter lösbar verbunden ist und dieser lösbar verbunden ist mit der Profilschiene.

Von Vorteil ist dabei, dass eine Box mit einer Profilschiene lösbar verbindbar ist. Somit ist in der Box Elektronik vorsehbar, die Funktionen entlang der Profilschienenstrecke ausführbar macht.

Weiter ist bei der Erfindung von Vorteil, dass die Profilschiene nicht angebohrt werden muss oder sonst wie beschädigt oder verändert werden muss. Hierzu ist der Halter vorgesehen. Er nutzt die bloße Ausformung der Profilschiene, insbesondere Nuten, und beschädigt diese in keiner Weise.

Die Position der Box ist entlang der Profilschiene frei wählbar. Denn die Profilschiene weist stets dasselbe Profil als Querschnitt auf entlang der gesamten Schiene. Somit liegt ein translatorischer Freiheitsgrad vor, der für die Positionierung der Box nutzbar ist.

Darüber hinaus ist die Box mittels des Halters werkzeuglos befestigbar. Dies ermöglicht eine besonders schnelle und einfache und somit auch kostengünstige Montage. Insbesondere die Lösbarkeit der Verbindung trägt hierzu ebenfalls bei.

Weiter ist von Vorteil, dass verschieden große Boxen verbindbar sind, insbesondere durch Verschieben der Halter in Schienenrichtung.

Die Halter sind kostengünstig anpassbar an verschiedene Profilschienenausführungen. Die kostspieligere Box bleibt jedoch stets gleich. Ebenso sind die Halter kostengünstig anpassbar an verschiedene Boxausführungen.

Von Vorteil ist weiter, dass beliebige Ausformungen von Profilschienen verwendbar sind. Einzige Bedingung zur Verwendbarkeit ist, dass die Profilschiene zwei parallele Oberflächenbereiche aufweisen, die einander zugewandt sind und der Verbindungszwischenraum zwischen diesen beiden Oberflächenbereichen verfügbar ist zum Einbringen der Halter. In Weiterbildung ist es vorteilhaft, die Profilschienen zwei, einander zugewandten Nuten zu versehen, so dass die parallelen Oberflächenbereiche Nutgründe darstellen.

Bei einer vorteilhaften Ausgestaltung ist die lösbare Verbindung zwischen Box und Halter mittels Befestigungsmitteln bewirkt, welche einen Oberflächenbereich, insbesondere Schienenboden der Profilschiene, berühren und während des Verbindens den Halter von diesem Oberflächenbereich zunehmend entfernen. Von Vorteil ist dabei, dass auf diese Weise der Halter gegen eine Seitenwand eines Vorsprungs anpressbar ist und somit die Pressverbindung bewirkbar ist.

Bei einer vorteilhaften Ausgestaltung umfassen die Befestigungsmittel zumindest Schrauben und/oder Muttern, insbesondere Schraubenköpfe aufweisende Schrauben. Alternativ sind auch Einpressmuttern als für die vorliegende Erfindung technisch äquivalent wirkende Befestigungsmittel verwendbar. Von Vorteil ist dabei, dass Schrauben schnell und einfach lösbar sind und somit die Box entlang der Schiene schnell und einfach versetzbar ist.

Bei einer vorteilhaften Ausgestaltung ist der Halter in Nuten der Profilschiene gehalten und wird beim Verbinden der Box mit dem Halter bis zur Berührung einer Nutseitenwand weggedrückt. Von Vorteil ist dabei, dass der Halter durch die Form, nämlich der Nuten und auch seiner Berührkontur gehalten ist und nur einen kleinen Bewegungsfreiheitsgrad aufweist. Innerhalb dessen ist er an die Nutseitenwand anpressbar und somit zum Herstellen der stabilen Verbindung für die Bos verwendbar.

Bei einer vorteilhaften Ausgestaltung ist der Halter mit der Profilschiene durch Drehbewegung in einen formschlüssigen Verbindungszustand mit der Profilschiene bringbar. Von Vorteil ist dabei, dass dies werkzeuglos erfolgen kann und somit die Verbindung in einfacher Weise schnell erfolgt.

Bei einer vorteilhaften Ausgestaltung steht der Halter mittels zweier gegenüberliegenden Oberflächenbereichen, insbesondere Berührkonturen, mit Nutgründen von Nuten der Profilschiene in Berührung. Von Vorteil ist dabei, dass der Halter nicht herausrutschen kann und somit gesichert ist. Insgesamt ist er nach dem Verbinden im Wesentlichen formschlüssig gesichert und verbunden, wobei in Schienenrichtung kraftschlüssige Verbindung vorliegt.

Bei einer vorteilhaften Ausgestaltung ist der jeweilige Oberflächenbereich gerade ausgeführt, insbesondere flach, und benachbarte Bereiche derart ausgeführt sind, dass bei der Drehbewegung des Halters dieser gerade Bereich im Wesentlichen gleichzeitig zum Anliegen am Nutgrund kommt. Von Vorteil ist dabei, dass beim Drehbewegen ein Einschnappen zu verspüren ist, wenn der gerade Oberflächenbereich im Wesentlichen gleichzeitig zum Eingriff kommt.

Bei einer vorteilhaften Ausgestaltung ist der Halter aus Metall gefertigt und die Profilschiene ist aus Aluminium, insbesondere als Strangguss, gefertigt oder aus einem anderen Metall. Von Vorteil ist dabei, dass eine kostengünstige Fertigung der Teile ermöglicht ist.

Alternativ ist der Halter aus Kunststoff gefertigt.

Bei einer vorteilhaften Ausgestaltung ist am Halter ein Federbereich ausgebildet, der Federkraft in Verbindungsrichtung der beiden gegenüberliegenden Nuten der Profilschiene erzeugt, insbesondere in welchen der Halter anliegt. Von Vorteil ist dabei, dass eine besonders stabile formschlüssige Verbindung herstellbar ist.

Bei einer vorteilhaften Ausgestaltung ist die Profilschiene eine EHB-Schiene. Von Vorteil ist dabei, dass solche Schienen die genannten Oberflächenbereiche schon aufweisen und somit nachrüstbar sind. Somit sind aber Einschienenhängebahnen (EHB) nachrüstbar auf berührungslose Energieversorgung. Schleifleitungen sind einsparbar und somit auch funkenfreie Energieübertragung an bewegbar angeordnete Verbraucher ermöglicht. Daher ist auch eine Anlage im explosionsgeschützten Bereich mit dieser berührungslosen Energieübertragungstechnik ausstattbar.

Bei einer vorteilhaften Ausgestaltung sind entlang der Profilschiene Primärleiter zur berührungslosen Energieversorgung entlang der Profilschiene bewegbar angeordneter Verbraucher vorgesehen. Von Vorteil ist dabei, dass die Verbraucher mit einer Sekundärspule ausstattbar sind, welche induktiv gekoppelt sind mit den Primärleitungen und somit die berührungslose Energieübertragung ermöglichen.

Bei einer vorteilhaften Ausgestaltung führen die Primärleiter mittelfrequenten Wechselstrom. Von Vorteil ist dabei, dass hohe Leistungen übertragbar sind und die Wechselströme mittels elektronischer Leistungshalbleiter, wie IGBT, einfach und kostengünstig herstellbar sind.

Bei einer vorteilhaften Ausgestaltung weist der mittelfrequente Wechselstrom 10 Ampere übersteigt und eine Frequenz zwischen 10 und 100 kHz auf. Von Vorteil ist dabei, dass industrielle Antriebe mit mehr als 300 W berührungslos versorgbar sind und Starkstrom induktiv übertragbar ist, insbesondere bei einer schwachen Kopplung, also einer gegenüber Transformatoren deutlich verringerten Kopplung.

Bei einer vorteilhaften Ausgestaltung umfasst die Box ein elektronische Bauelemente umschließendes Gehäuse. Insbesondere weist die Box Bauelemente zur Streckenkompensation auf, wie insbesondere Kondensator. Von Vorteil ist dabei, dass in regelmäßigen Abständen Kondensatoren entlang der Schiene vorsehbar sind, die zur Kompensation der Streckeninduktivität eines Primärleiters derart dimensioniert sind, dass die Resonanzfrequenz der Induktivitäten zusammen mit den Kapazitäten der eingespeisten Wechselstromfrequenz im Primärleiter entspricht.

Bei einer vorteilhaften Ausgestaltung weist die Box Anschlussvorrichtungen auf, an denen die Primärleiter elektrisch verbunden sind mit Versorgungsleitungen. Von Vorteil ist dabei, dass die Anschlussvorrichtungen in geschützter Art vorsehbar sind an beliebigen Stellen entlang der Schiene.

Bei einer vorteilhaften Ausgestaltung ist die Box weniger breit als der Abstand zwischen den sich gegenüberliegenden Nuten oder Vorsprüngen. Vorteiligerweise sind schmale Boxen vorsehbar, die also nicht direkt die Profilschiene berühren sondern nur am Halter befestigbar sind.

Bei einer alternativen vorteilhaften Ausgestaltung ist die lösbare Verbindung zwischen Box und Halter mittels Befestigungsmitteln derart bewirkt, dass Halter und Box an einen zwischen ihnen liegenden Vorsprung anklemmbar sind. Von Vorteil ist dabei, dass eine einfache Ausformung, nämlich der Vorsprung, nutzbar ist für das Anklemmen und somit stabile verbinden der Box mittels des Halters an die Profilschiene.

Bei einer vorteilhaften Ausgestaltung umfassen die Befestigungsmittel zumindest Schrauben und/oder Muttern, insbesondere Schraubenköpfe aufweisende Schrauben. Von Vorteil ist dabei, dass einfache und kostengünstige Mittel verwendbar sind. Alternativ sind auch Einpressmuttern als für die vorliegende Erfindung technisch äquivalent wirkende Befestigungsmittel verwendbar.

Bei einer vorteilhaften Ausgestaltung ist der Halter in Nuten der Profilschiene gehalten und wird beim Verbinden der Box mit dem Halter der Halter an eine Nutseitenwand, also an eine erste Seitenwand des Vorsprungs, angedrückt. Von Vorteil ist dabei, dass eine solche Wand durch bloße Formung des Profils vorsehbar ist und somit kostengünstig erzeugbar.

Bei einer vorteilhaften Ausgestaltung ist die Nut nicht rechteckförmig sondern weist ein anderes Profil auf, beispielsweise ein rundes, abschnittsweise kreisförmiges oder vieleckiges. Der Halter ist im Kontaktbereich zu dieser Nut entsprechend geformt, beispielsweise weist er im Profil Kreissegmente auf. Die Verspannung des Halters in den beiden sich gegenüberliegenden Nuten erfolgt entsprechend.

Bei einer vorteilhaften Ausgestaltung ist die Box breiter als der Abstand zwischen den sich gegenüberliegenden Vorsprüngen, die für das Anklemmen verwendet sind. Von Vorteil ist dabei, dass breite Boxen einfach und stabil verbindbar sind.

Weitere Vorteile ergeben sich aus den Unteransprüchen.

Die Erfindung wird nun anhand von Abbildungen näher erläutert:
In der Figur 1a ist ein erfindungsgemäßes System gezeigt, vor dem vollständigen Verbinden der Box 3.

In der Figur 1b ist das erfindungsgemäße System gezeigt, nach dem vollständigen Verbinden der Box 3.

In der Figur 1c ist das System in Schrägansicht gezeigt.

In der Figur 2a ist ein anderes erfindungsgemäßes System gezeigt, vor dem vollständigen Verbinden der Box 3.

In der Figur 2b ist dieses System gezeigt, nach dem vollständigen Verbinden der Box 3.

In der Figur 2c ist dieses System in Schrägansicht gezeigt.

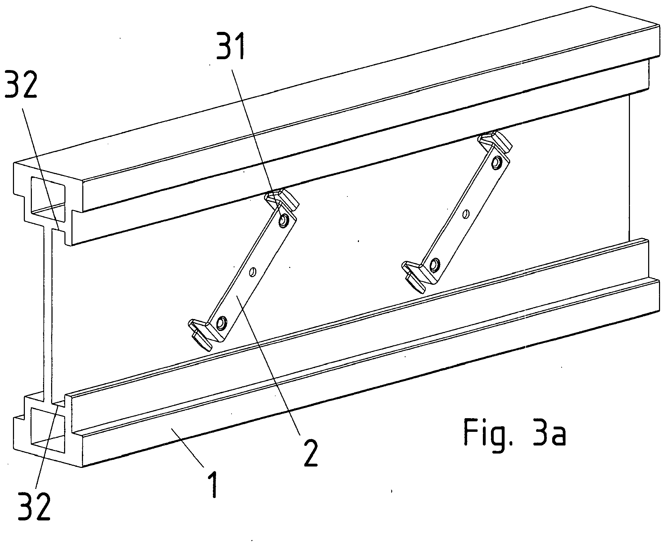

In der Figur 3a ist die Profilschiene 1 gezeigt, wobei der Halter 2 eingelegt ist im Bereich zwischen zwei sich gegenüber stehenden Nuten mit jeweiligem Nutgrund 32.

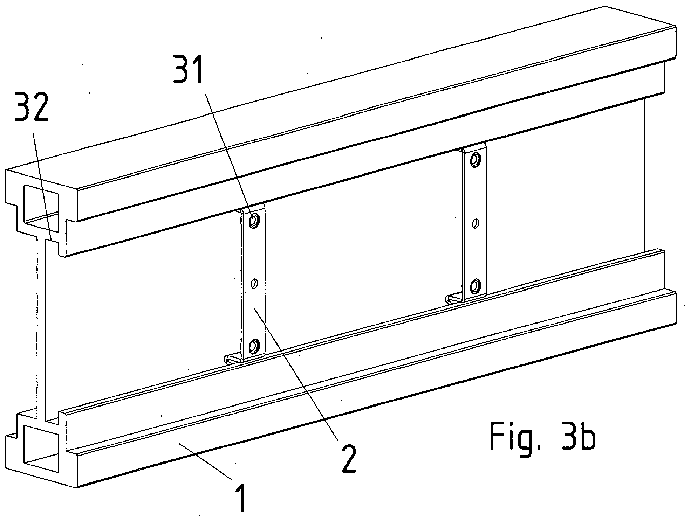

In der Figur 3b ist der Halter 2 nach dem Ausführen einer Drehbewegung gezeigt. Dabei ist der Halter 2 an den Nuten formschlüssig gehalten. Der Halter weist Bohrungen 31 zur Aufnahme von Schrauben 4 auf.

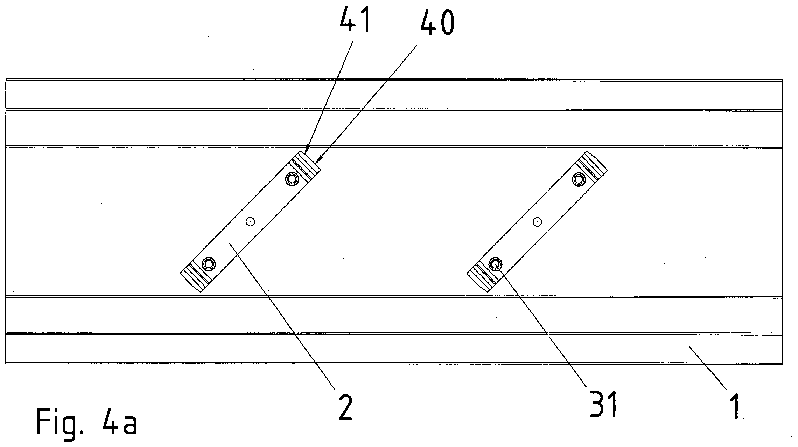

In Figur 4a ist eine Draufsicht gezeigt, die zu Figur 3a gehört.

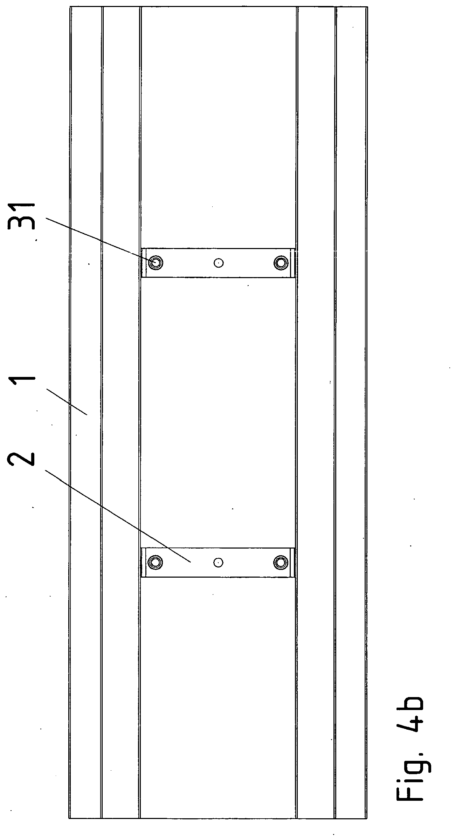

In Figur 4b ist eine Draufsicht gezeigt, die zu Figur 3b gehört.

Dabei ist klar gezeigt, dass die Berührfläche zwischen Halter 2 und Profilschiene 1 als gerade Berührkontur 40 ausgeführt ist, der ein abgeschrägt verlaufender Bereich 41 nebengeordnet ist. Somit kommt beim Drehen des Halters 2 die gerade Berührkontur im Wesentlichen gleichzeitig zum Anliegen am Nutgrund 32. Der abgeschrägt Bereich 41 erleichtert die Drehbewegung. Zwischen den beiden Bereichen ist ein Knick angeordnet, der das plötzliche Anliegen ermöglicht. Auf diese Weise ist also beim Drehen ein plötzliches Einschnappen des Halters am Nutgrund ausgeführt und es ist dann eine formschlüssige Verbindung des Halters 31 an den Nuten der Profilschiene 1 realisiert.

Zur Verbesserung des Haltens und zum Erleichtern des Drehens ohne Werkzeug wird der Halter 2 als teilweise elastisches Blech ausgeführt. Dabei ist die Federkraft in Verbindungsrichtung der beiden Nuten der Profilschiene gerichtet und wird durch die Verformung des Halters erzeugt.

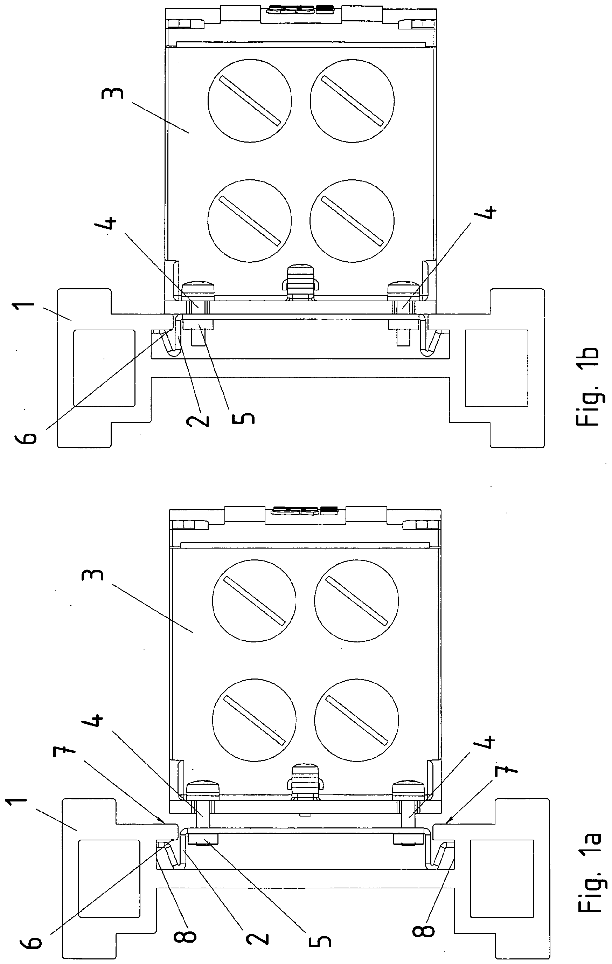

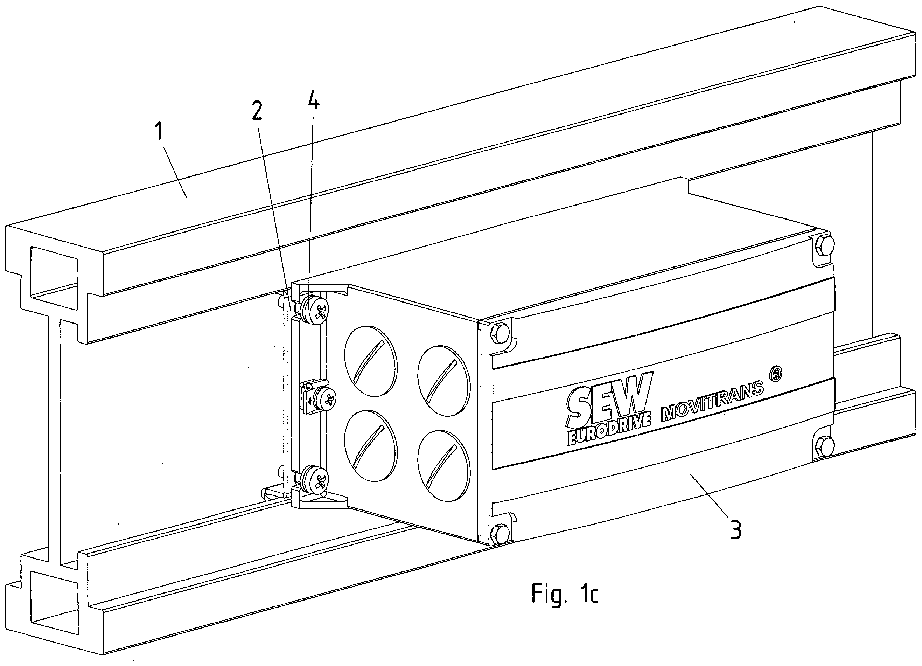

An dem Halter wird eine Box 3 befestigt, wie in Figur 1a, 1b und 1c gezeigt ist.

Die Box wird mit in den Bohrungen 31 vorgesehenen Schrauben 4 am Halter 2 befestigt. Beim Drehen der Schrauben 4 wird der Abstand zwischen Halter 2 und Box 3 verringert. Hierzu ist am Endbereich der Schraubengewinde eine Mutter 5 vorgesehen.

Bei Verringerung des Abstandes wird der Halter an die Nutseitenwand 6 und die Box an die äußere Vorsprungsaußenfläche 7 geklemmt. Somit ist die Box mittels des Halters an den Vorsprung, welcher benachbart ist zur Nut angeklemmt.

Wichtig ist hierbei also, dass die Box eine derart große Breite aufweist, dass sie an den sich gegenüberliegenden Vorsprüngen auflegbar ist.

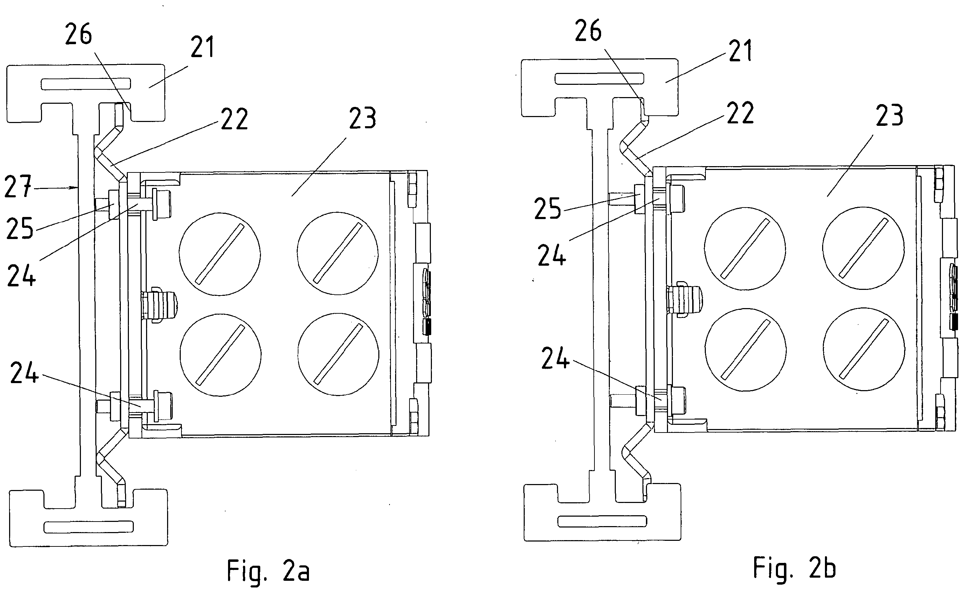

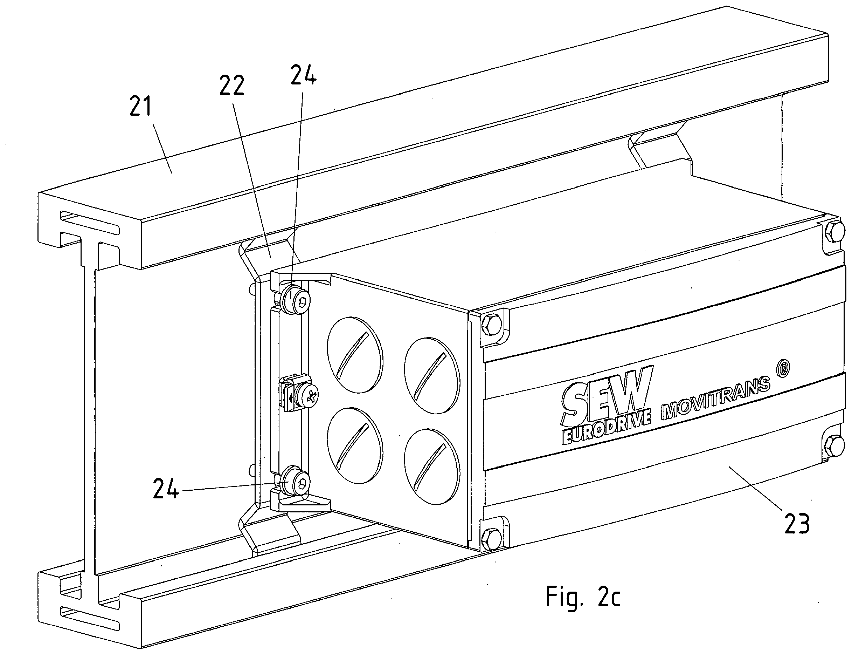

In den Figuren 2a, 2b und 2c ist ein alternatives erfindungsgemäßes Ausführungsbeispiel gezeigt. Dabei weist die Profilschiene 21 wiederum einen Nut mit einer Nutseitenwand 26 auf, jedoch wird die Box nicht an einem Vorsprung angeklemmt. Denn die Box kann hier mit einer sehr geringen Breite ausgeführt werden, insbesondere viel geringer als der Abstand der sich gegenüberliegenden Vorsprüngen oder Nuten.

Wiederum sind in Löchern des Halters 22 Schrauben 24 mit Muttern 25 vorgesehen. Jedoch stützen sich die Schrauben beim Einschrauben am Boden 27 der Profilschiene 21 ab. Dadurch wird der Halter vom Boden 27 weggeschoben, also in dessen Normalenrichtung. Erst wenn der Halter die Nutseitenwand 26 berührt, hat der Halter 22 seine stabile Endposition erreicht und ist somit stabil verbunden. Die Box 23 ist also über den Halter 22 insgesamt formschlüssig verbunden mit der Profilschiene 21, wobei in Schienenrichtung eine kraftschlüssige Verbindung vorliegt und in den beiden anderen kartesischen Richtungen eine formschlüssige Verbindung vorliegt.

### Bezugszeichenliste

1 Profilschiene
2 Halter
3 Box
4 Schraube
5 Mutter
6 Nutseitenwand
7 Vorsprungsaußenfläche
8 Nutgrund
21 Profilschiene
22 Halter
23 Box
24 Schraube
25 Mutter
26 Nutseitenwand
27 Schienenboden

31 Bohrung
32 Nutgrund
40 Berührkontur, gerade
41 Abschrägung, abgeschrägte Kontur

## Patentansprüche

1. System für elektrische Energieversorgung, umfassend Profilschiene (1, 21), Halter (2, 22) und Box (3, 23),
wobei der Halter (2, 22) Bohrungen (31) zur Aufnahme von Schrauben (4) aufweist,
wobei die Box (3, 23) mit in den Bohrungen (31) vorgesehenen Schrauben (4) am Halter (2, 22) befestigt ist,
wobei die Box (3, 23) am Halter (2, 22) lösbar verbunden ist und dieser lösbar verbunden ist mit der Profilschiene (1, 21),
wobei der Halter (2, 22) mit der Profilschiene (1, 21) durch eine Drehbewegung des Halters (2, 22) in einen formschlüssigen Verbindungszustand mit der Profilschiene (1, 21) gebracht ist,
**dadurch gekennzeichnet, dass**
die Drehachse senkrecht auf der Profilschiene (1, 21) steht,
dass der Halter (2, 22) mittels zweier, am Halter (2, 22), gegenüberliegenden Oberflächenbereichen, also Berührkonturen, mit zwei, vom Halter (2, 22) aus gesehen, entsprechend gegenüberliegenden Nutoberflächen der Profilschiene (1, 21) in Berührung steht
und/oder
der Halter (2, 22) mittels zweier, am Halter (2, 22), gegenüberliegenden Oberflächenbereichen, also Berührkonturen, mit Nutgründen von zueinander parallel ausgerichteten Nuten der Profilschiene (1, 21) in Berührung steht,
dass der Halter (2, 22) elastisch derart verformt ist, dass eine in Verbindungsrichtung der beiden zueinander parallel ausgerichteten Nuten der Profilschiene (1, 21) gerichtete Federkraft erzeugt wird,
und dass der jeweilige Oberflächenbereich gerade ausgeführt ist, insbesondere flach, und am jeweiligen Nutgrund (8, 32) anliegt, wobei die Kontur des Halters (2, 22) vom jeweiligen Oberflächenbereich in einen gebogenen Bereich übergeht.

2. System nach Anspruch 1,
**dadurch gekennzeichnet, dass**
der Halter (2, 22) in Nuten der Profilschiene (1, 21) gehalten ist und beim Verbinden der Box (3, 23) mit dem Halter (2, 22) bis zur Berührung einer Nutseitenwand (6, 26) weggedrückt wird.

3. System nach mindestens einem der vorangegangenen Ansprüche,
**dadurch gekennzeichnet, dass**
die Box (3, 23) weniger breit ist als der Abstand zwischen den sich gegenüberliegenden Nuten oder Vorsprüngen.

## Claims

1. A system for supplying electrical energy, comprising a profiled rail (1, 21), a holder (2, 22) and a box (3, 23),
wherein the holder (2, 22) has bores (31) for receiving screws (4),
wherein the box (3, 23) is secured to the holder (2, 22) by screws (4) that are provided in the bores (31),
wherein the box (3, 23) is detachably connected to the holder (2, 22) and the latter is detachably connected to the profiled rail (1, 21),
wherein the holder (2, 22), together with the profiled rail (1, 21), is brought into a condition of being form-fittingly connected to the profile rail (1, 21) by a rotary movement of the holder (2, 22),
**characterised**
**in that** the axis of rotation is perpendicular to the profiled rail (1, 21),
**in that**, by means of two opposing surface regions on the holder (2, 22), that is to say contact contours, the holder (2, 22) is in contact with two groove faces of the profiled rail (1, 21) that are correspondingly in opposition, as seen from the holder (2, 22),
and/or
by means of two opposing surface regions on the holder (2, 22), that is to say contact contours, the holder (2, 22) is in contact with groove roots of mutually parallel grooves in the profiled rail (1, 21),
**in that** the holder (2, 22) is resiliently deformed such that a spring force is generated in the direction in which the two mutually parallel grooves in the profiled rail (1, 21) are connected,
and **in that** the respective surface region takes a straight form, in particular being flat, and abuts against the respective groove root (8, 32), wherein the contour of the holder (2, 22) merges from the respective surface region into a curved region.

2. A system according to Claim 1,
**characterised in that**
the holder (2, 22) is held in grooves in the profiled rail (1, 21) and, when the box (3, 23) is connected to the holder (2, 22), is pressed away until it makes contact with a groove side wall (6, 26).

3. A system according to at least one of the preceding claims,
**characterised in that**
the box (3, 23) is less wide than the spacing between the opposing grooves or projections.

## Revendications

1. Système dévolu à l'alimentation en énergie électrique,
composé d'un rail profilé (1, 21), d'un support (2, 22) et d'un boîtier (3, 23),
le support (2, 22) étant muni de perçages (31) destinés à recevoir des vis (4),
le boîtier (3, 23) étant fixé audit support (2, 22) par des vis (4) prévues dans lesdits perçages (31),
ledit boîtier (3, 23) étant relié amoviblement audit support (2, 22), lequel est relié amoviblement audit rail profilé (1, 21),
le support (2, 22) étant amené conjointement au rail profilé (1, 21), par un mouvement rotatoire dudit support (2, 22), à un état de liaison par complémentarité de formes avec ledit rail profilé (1, 21),
**caractérisé par le fait que**
l'axe de rotation se dresse verticalement sur le rail profilé (1, 21) ;
**par le fait que** le support (2, 22) est en contact, au moyen de deux zones de surface situées en vis-à-vis sur ledit support (2, 22) et se présentant, par conséquent, comme des profils de mise en contact, avec deux surfaces de rainures du rail profilé (1, 21) placées avec vis-à-vis correspondant en considérant à partir dudit support (2, 22),
et/ou
que ledit support (2, 22) est en contact, au moyen de deux zones de surface situées en vis-à-vis sur ledit support (2, 22) et se présentant, par conséquent, comme des profils de mise en contact, avec des fonds de rainures dudit rail profilé (1, 21) qui sont orientées avec parallélisme mutuel ;
**par le fait que**
ledit support (2, 22) est déformé élastiquement, de façon à engendrer une force élastique pointant dans la direction de liaison des deux rainures du rail profilé (1, 21) qui sont orientées parallèlement l'une à l'autre ;
et **par le fait que**
la zone de surface considérée est de réalisation rectiligne, notamment aplatie, et porte contre le fond respectif (8, 32) d'une rainure, le profil dudit support (2, 22) fusionnant dans une région curviligne à partir de ladite zone de surface considérée.

2. Système selon la revendication 1,
**caractérisé par le fait que**
le support (2, 22) est retenu dans des rainures du rail profilé (1, 21) et est repoussé à l'écart, lors de la liaison du boîtier (3, 23) avec ledit support (2, 22), jusqu'à venir au contact de la paroi latérale (6, 26) d'une rainure.

3. Système selon au moins l'une des revendications précédentes,
**caractérisé par le fait que**
la largeur du boîtier (3, 23) est inférieure à la distance comprise entre les rainures ou les protubérances placées en vis-à-vis.
